# EUROPEAN PATENT SPECIFICATION

(11) **EP 3 061 789 B1**
(45) Date of publication and mention of the grant of the patent: **30.05.2018**
(21) Application number: 14856363.8
(22) Date of filing: 20.10.2014
(51) Int. Cl.: C08L 65/00, B32B 15/08, C08J 5/24, C08K 3/00, C08K 5/29, C08K 5/315, C08L 63/00, C08L 79/04

(54) **RESIN COMPOSITION, PREPREG, LAMINATED SHEET, AND METAL-FOIL-CLAD LAMINATED BOARD**
HARZZUSAMMENSETZUNG, PREPREG, LAMINATFOLIE UND MIT EINER METALLFOLIE KASCHIERTE LAMINATPLATTE
COMPOSITION DE RÉSINE, PRÉIMPRÉGNÉ, FEUILLE STRATIFIÉE, ET CARTE STRATIFIÉE REVÊTUE D'UN FEUIL MÉTALLIQUE

(30) Priority: 25.10.2013 JP 2013222023
(43) Date of publication of application: 31.08.2016
(73) Proprietor: Mitsubishi Gas Chemical Company, Inc., Tokyo 100-8324 (JP)
(72) Inventor: ARII, Kenji, Nara 6300244 (JP); KOBAYASHI, Takashi, Tokyo 125-8601 (JP); SOGAME, Masanobu, Tokyo 100-8324 (JP); MABUCHI, Yoshinori, Tokyo 125-8601 (JP); MISHIMA, Hiroyuki, Tokyo 100-8324 (JP)
(74) Representative: Hoffmann Eitle
(86) International application number: PCT/JP2014/077870
(87) International publication number: WO 2015/060266

(56) References cited:
- EP-A1- 1 566 377
- EP-A1- 2 578 631
- WO-A1-2012/165423
- JP-A- 2005 264 154
- JP-A- 2007 045 968
- JP-A- 2007 045 984
- JP-A- 2014 118 428
- JP-A- 2014 185 272

## Description

### Technical Field

The present invention relates to a resin composition, a prepreg using the same, and a resin sheet and a metal foil clad laminate which use the resin composition or the prepreg.

### Background Art

In printed wiring boards widely used in electronic equipment, communication instruments, and personal computers, or the like, high-density wiring and higher integration progress. With this, laminates having excellent properties such as heat resistance, low water-absorbing property, heat resistance after moisture absorption, and insulating reliability are required of metal foil clad laminates used in printed wiring boards. Conventionally, FR-4 type laminates in which epoxy resins are cured with dicyandiamide have been widely used as laminates for printed wiring boards. However, it was difficult to cope with a demand for high heat resistance by means of such laminates. A cyanate ester compound has been known as a resin for printed wired boards having excellent heat resistance. For example, in recent years, resin compositions containing bisphenol A-based cyanate ester compounds and another thermosetting resins or thermoplastic resins have been widely used as materials for high function printed wiring boards, such as for semiconductor plastic packages, or the like. The bisphenol A-based cyanate ester compound has excellent properties in electrical properties, mechanical properties, chemical resistance, and adhesiveness, or the like. However, the cyanate ester compound may be insufficient in terms of low water-absorbing property, heat resistance after moisture absorption, and flame retardancy under severe conditions. Therefore, with the aim of further improving properties, cyanate ester compounds having other structures have been studied.

Many documents using novolac-based cyanate ester compounds as the cyanate ester compounds having other structures have been known (for example, see Patent Document 1). However, the novolac-based cyanate ester compound has been problematic in that it readily causes insufficient hardness, and in that the obtained hardened product has a high water absorption rate and decreased heat resistance after moisture absorption. A prepolymer containing a novolac-based cyanate ester compound and a bisphenol A-based cyanate ester compound has been disclosed as a method for improving the curability of the novolac-based cyanate ester compound (for example, see Patent Document 2). Although the prepolymer has improved curability, the prepolymer is insufficient in terms of low water-absorbing property and heat resistance after moisture absorption. Therefore, cyanate ester compounds which are excellent in these properties have been desired.

On the other hand, as a method for improving the flame retardancy of a resin composition containing a cyanate ester compound, it has been proposed to use a fluorinated cyanate ester compound, or to mix a cyanate ester compound with a halogen-based compound or prepolymerize these compounds, so as to allow a resin composition to contain the halogen-based compound (see Patent Documents 3 and 4). However, when the halogen-based compound is used, there is a risk that a harmful substance such as dioxin may be generated during combustion. Accordingly, it has been desired to improve the flame retardancy of a resin composition containing a cyanate ester compound without containing a halogen-based compound.

A naphthol aralkyl-based cyanate ester compound has been proposed as a cyanate ester compound which has improved flame retardancy without containing a halogen-based compound and is excellent in properties such as low water-absorbing property and heat resistance after moisture absorption (see Patent Document 5). However, when the compound is stored in a state where it is dissolved in a solvent such as methyl ethyl ketone, a part of the compound is deposited as a temperature decreases, which makes it difficult to maintain a homogeneous solution. Hence, it has been desired to improve the solvent solubility of a resin composition containing a cyanate ester compound.

### Citation List

### Patent Document

Patent Document 1: Japanese Patent Application Laid-Open No. 11-124433
Patent Document 2: Japanese Patent Application Laid-Open No. 2000-191776
Patent Document 3: Japanese Patent Publication No. 3081996
Patent Document 4: Japanese Patent Application Laid-Open No. 6-271669
Patent Document 5: Japanese Patent Publication No. 4997727

### Summary of Invention

### Technical Problem

The present invention has been made in view of the above circumstances, and it is an object of the present invention to provide a resin composition which can realize a printed wired board having not only low water-absorbing property but also excellent heat resistance after moisture absorption, flame retardancy, and solvent solubility. It is another object of the present invention to provide a prepreg and a laminate which use the resin composition, and a metal foil clad laminate and a printed wired board which use the prepreg.

### Solution to Problem

As a result of intensive investigations in order to achieve the objects, the present inventors found that low water-absorbing property and excellent heat resistance after moisture absorption, flame retardancy, and solvent solubility can be realized by using a resin composition containing a cyanate ester compound obtained by cyanation of a naphthol-modified meta-xylene glycol resin, thereby completing the present invention. Specifically, the present invention is as follows.
[1] A resin composition containing one or two or more cyanate ester compounds (A) represented by the following formula (1) and an epoxy resin (B): 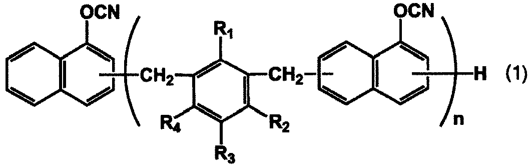 wherein R₁, R₂, R₃, and R₄ represent a hydrogen atom or an alkyl group having 1 to 10 carbon atoms, and may be the same or different from each other; and n represents an integer of 1 to 50.
[2] The resin composition according to [1], wherein a content of the cyanate ester compound (A) is 1 to 90 parts by mass based on 100 parts by mass of a resin solid content in the resin composition.
[3] The resin composition according to [1] or [2], further containing an inorganic filler (C).
[4] The resin composition according to [3], wherein a content of the inorganic filler (C) is 50 to 1600 parts by mass based on 100 parts by mass of a resin solid content in the resin composition.
[5] The resin composition according to any one of [1] to [4], further containing one or more compounds selected from the group consisting of a maleimide compound and a cyanate ester compound other than the cyanate ester compound (A).
[6] The resin composition according to any one of [1] to [5], wherein the epoxy resin (B) is one or more selected from the group consisting of a biphenyl aralkyl-based epoxy resin, a naphthylene ether-based epoxy resin, a multifunctional phenol-based epoxy resin, and a naphthalene-based epoxy resin.
[7] A prepreg containing a base material and the resin composition according to any one of [1] to [6] with which the base material is impregnated or coated.
[8] A metal foil clad laminate containing one or more of the prepreg according to [7] and a metallic foil disposed on one or both surfaces of the prepreg.
[9] A laminate including a support and a resin layer formed on a surface of the support by coating and drying of the resin composition according to any one of [1] to [6].
[10] A printed wiring board including an insulating layer and a conductor layer formed on a surface of the insulating layer, wherein the insulating layer contains the resin composition according to any one of [1] to [6].

### Advantageous Effects of Invention

The present invention can provide a resin composition which can realize a printed wired board having not only low water-absorbing property but also excellent heat resistance after moisture absorption, flame retardancy, and solvent solubility, a prepreg and a laminate which use the resin composition, and a metal foil clad laminate and a printed wired board which use the prepreg.

### Description of Embodiments

Hereinafter, embodiments for carrying out the present invention (hereinafter, merely referred to as "the present embodiment") will be described in detail. The following present embodiment is illustration for explaining the present invention, and the present invention is not limited only to the present embodiment.

A resin composition of the present embodiment contains one or two or more cyanate ester compounds (A) represented by the following formula (1) and an epoxy resin (B): 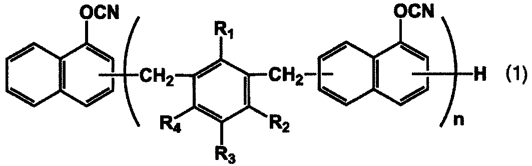 wherein R₁, R₂, R₃, and R₄ represent a hydrogen atom or an alkyl group having 1 to 10 carbon atoms, and may be the same or different; and n represents an integer of 1 to 50.

The cyanate ester compound (A) used in the present embodiment is obtained by cyanation of a naphthol-modified meta-xylene glycol resin. R₁, R₂, R₃, and R₄ each independently represent, preferably a hydrogen atom or an alkyl group having 1 to 6 carbon atoms, and more preferably a hydrogen atom or a alkyl group having 1 to 3 carbon atoms. At least one of R₁, R₂, R₃, and R₄ is preferably a hydrogen atom, and three of R₁, R₂, R₃, and R₄ are more preferably a hydrogen atom.

The cyanate ester compound (A) having such a structure imparts not only excellent low water-absorbing property but also good heat resistance after moisture absorption, flame retardancy, and solvent solubility to a metal foil clad laminate or the like produced using the cyanate ester compound (A).

The weight-average molecular weight Mw of the cyanate ester compound (A) of the present embodiment is not particularly limited, and is preferably 200 to 25000, more preferably 250 to 20000, and still more preferably 300 to 15000 from the viewpoint of more effectively and certainly exhibiting the function effect of the present invention. The weight-average molecular weight Mw is measured based on a method described in the following Examples.

The cyanate ester compound (A) of the present embodiment is obtained by, for example, cyanation of a hydroxyl group of a naphthol-modified meta-xylene glycol resin represented by the following formula (2). The method for cyanation is not particularly limited, and known methods can be applied. Specific examples thereof include a method in which a naphthol-modified meta-xylene glycol resin is reacted with a cyanogen halide in a solvent in the presence of a base such that the cyanogen halide is always present in excess of the base as described in U.S. Pat. No. 3,553,244. Another examples of the method for cyanation include a method in which a tertiary amine is used as a base in excess of a cyanogen halide and added to a naphthol-modified meta-xylene glycol resin in the presence of a solvent, and thereafter dropping the cyanogen halide, or in which both the cyanogen halide and the tertiary amine are dropped into the naphthol-modified meta-xylene glycol resin as described in Japanese Patent Publication No. 3319061. Still another examples thereof include a method in which a naphthol-modified meta-xylene glycol resin, a trialkylamine, and a cyanogen halide are reacted in a continuous plug flow mode as described in Japanese Patent Publication No. 3905559. Yet still other examples thereof include a method in which a tert-ammonium halide, which is produced as a by-product in reacting a naphthol-modified meta-xylene glycol resin with a cyanogen halide in a nonaqueous solution in the presence of a tert-amine, is treated with a cation and anion exchange pair, as described in Japanese Patent Publication No. 4055210. Further examples thereof include a method in which a naphthol-modified meta-xylene glycol resin is reacted in the presence of a solvent separable from water by simultaneously adding a tertiary amine and a cyanogen halide, followed by water washing and separation, and precipitation and purification from the obtained solution using a poor solvent of a secondary or tertiary alcohol or a hydrocarbon as described in Japanese Patent Publication No. 2991054. Still further examples thereof include a method in which a naphthol-modified meta-xylene glycol resin, a cyanogen halide, and a tertiary amine are reacted in a two-phase solvent of water and an organic solvent under acidic conditions as described in Japanese Patent Publication No. 5026727. In the present embodiment, the cyanate ester compound (A) can be obtained suitably using these methods.

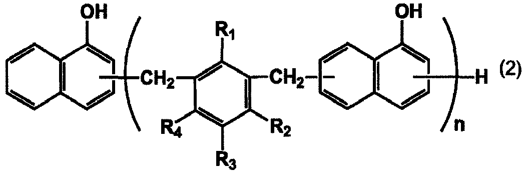

Herein, in the formula, R₁, R₂, R₃, and R₄ represent a hydrogen atom or an alkyl group having 1 to 10 carbon atoms, and may be the same or different from each other. n represents an integer of 1 to 50, and preferably an integer of 1 to 10. The naphthol-modified meta-xylene glycol resins represented by the formula (2) are used singly or in combination of two or more. Herein, "two or more" of resins may have different n, different substituent groups, or both different n and different substituent groups. R₁, R₂, R₃, and R₄ each independently represent, preferably a hydrogen atom or an alkyl group having 1 to 6 carbon atoms, and more preferably a hydrogen atom or an alkyl group having 1 to 3 carbon atoms. At least one of R₁, R₂, R₃, and R₄ is preferably a hydrogen atom, and four thereof are more preferably a hydrogen atom.

The method for producing the naphthol-modified meta-xylene glycol resin used as a raw material of the cyanate ester compound (A) of the present embodiment is not particularly limited, and examples thereof include a method for allowing a bishalogenomethyl compound represented by Ar-(CH₂Y)₂ to react with naphthol with an acidic catalyst or with no catalysts according to a known method, and a method for allowing a bis(alkoxymethyl) compound represented by Ar-(CH₂OR)₂ or a bis(hydroxymethyl) compound represented by Ar-(CH₂OH)₂ to react with naphthol in the presence of an acidic catalyst. Herein, Ar represents an aryl group; Y represents a halogen compound; and R represents an alkyl group.

The content of the cyanate ester compound (A) obtained by cyanation of the thus obtained naphthol-modified meta-xylene glycol resin in the resin composition of the present embodiment can be appropriately set according to desired properties, and is not particularly limited. From the viewpoint of more effectively and certainly exhibiting the function effect of the present invention, the content of the cyanate ester compound (A) is preferably 1 to 90 parts by mass, more preferably 10 to 80 parts by mass, and still more preferably 20 to 70 parts by mass, based on 100 parts by mass of a resin solid content in the resin composition.

The term "resin solid content in the resin composition" is used herein to mean resin components contained in the resin composition and components serving as resin components during heating, unless otherwise specified. For example, when the resin composition contains the cyanate ester compound (A), and an epoxy resin (B), a solvent, an inorganic filler (C), and a curing accelerator which will be described later, the term "resin solid content in the resin composition" is used herein to mean components except for a solvent, an inorganic filler (C), and a curing accelerator. The term "100 parts by mass of a resin solid content" is used to mean that a total of components except for a solvent, an inorganic filler (C), and a curing accelerator in the resin composition is 100 parts by mass.

As the epoxy resin (B) of the present embodiment, a known epoxy resin can be appropriately used, as long as it is a compound having two or more epoxy groups in one molecule, and the type of the epoxy resin is not particularly limited. Specific examples of the epoxy resin include a bisphenol A-based epoxy resin, a bisphenol E-based epoxy resin, a bisphenol F-based epoxy resin, a bisphenol S-based epoxy resin, a phenol novolac-based epoxy resin, a bisphenol A novolac-based epoxy resin, a glycidyl ester-based epoxy resin, an aralkyl novolac-based epoxy resin, a biphenyl aralkyl-based epoxy resin, a naphthylene ether-based epoxy resin, a cresol novolac-based epoxy resin, a multifunctional phenol-based epoxy resin, a naphthalene-based epoxy resin, an anthracene-based epoxy resin, a naphthalene skeleton-modified novolac-based epoxy resin, a phenol aralkyl-based epoxy resin, a naphthol aralkyl-based epoxy resin, a dicyclopentadiene-based epoxy resin, a biphenyl-based epoxy resin, an alicyclic epoxy resin, a polyol-based epoxy resin, a phosphorus-containing epoxy resin, a compound obtained by epoxidation of a double bond of glycidyl amine, glycidyl ester, and butadiene or the like, and a compound obtained by a reaction of a hydroxyl group-containing silicon resin with epichlorohydrin. Among these epoxy resins, the biphenyl aralkyl-based epoxy resin, the naphthylene ether-based epoxy resin, the multifunctional phenol-based epoxy resin, and the naphthalene-based epoxy resin are preferable in terms of flame retardancy and heat resistance. These epoxy resins can be used singly or in combination of two or more.

The content of the epoxy resin (B) in the present embodiment can be appropriately set according to desired properties and is not particularly limited. The content of the epoxy resin (B) is preferably 5 to 99 parts by mass, more preferably 15 to 90 parts by mass, and still more preferably 20 to 70 parts by mass, based on 100 parts by mass of a resin solid content in the resin composition.

The resin composition of the present embodiment can also contain an inorganic filler (C). As the inorganic filler (C), a known inorganic filler can be appropriately used, and the type of the inorganic filler (C) is not particularly limited. As the inorganic filler (C), inorganic fillers generally used for laminate applications can be preferably used. Specific examples of the inorganic filler (C) include silicas, such as natural silica, fusion silica, synthetic silica, amorphous silica, AEROSIL, and hollow silica, white carbon, titanium white, zinc oxide, magnesium oxide, zirconium oxide, boron nitride, aggregated boron nitride, silicon nitride, aluminum nitride, barium sulfate, aluminum hydroxide, heat-treated products of aluminum hydroxide (products obtained by heat-treating aluminum hydroxide to decrease some of the water of crystallization), boehmite, metal hydrates such as magnesium hydroxide, molybdenum compounds such as molybdenum oxide and zinc molybdate, zinc borate, zinc stannate, alumina, clay, kaolin, talc, calcined clay, calcined kaolin, calcined talc, mica, E-glass, A-glass, NE-glass, C-glass, L-glass, D-glass, S-glass, M-glass G20, glass short fibers (including glass fine powders of E-glass, T-glass, D-glass, S-glass, and Q-glass, or the like), hollow glass, and spherical glass. These inorganic fillers (C) are used singly or in combination of two or more. The resin composition contains the inorganic filler (C), which can particularly have more excellent low water-absorbing property, heat resistance after moisture absorption, and flame retardancy.

The resin composition of the present embodiment may contain the inorganic filler (C), as well as organic fillers such as styrene-based, butadiene-based and acryl-based rubber powders, coreshell-based rubber powders, silicon resin powders, silicon rubber powders, and silicon composite powders. These organic fillers can be used singly or in combination of two or more.

When the resin composition of the present embodiment contains the inorganic filler (C), the content of the inorganic filler (C) can be appropriately set according to desired properties, and is not particularly limited. The content thereof is preferably 50 to 1600 parts by mass, more preferably 60 to 600 parts by mass, and still more preferably 70 to 300 parts by mass, based on 100 parts by mass of a resin solid content in the resin composition. When the resin composition contains an organic filler, the total amount of the organic filler and inorganic filler (C) is preferably 50 to 1600 parts by mass, more preferably 60 to 600 parts by mass, and still more preferably 70 to 300 parts by mass, based on 100 parts by mass of a resin solid content in the resin composition.

Herein, at least one of the silane coupling agent and the moisture dispersant is preferably combined with the inorganic filler (C) from the viewpoint of increasing an interaction with a resin component to increase the mechanical strengths of the laminate, metal foil clad laminate, and printed wiring board. As the silane coupling agent, a silane coupling agent generally used for the surface treatment of inorganic matters can be preferably used. The type of the silane coupling agent is not particularly limited. Specific examples of the silane coupling agent include: aminosilane-based coupling agents such as γ-aminopropyltriethoxysilane and N-β-(aminoethyl)-γ-aminopropyltrimethoxysilane; epoxysilane-based coupling agents such as γ-glycidoxypropyltrimethoxysilane and β-(3,4-epoxycyclohexyl)ethyltrimethoxysilane; vinylsilane-based coupling agents such as γ-methacryloxypropyltrimethoxysilane and vinyl-tri(p-methoxyethoxy)silane; cationic silane coupling agents such as N-β-(N-vinylbenzylaminoethyl)-γ-aminopropyltrimethoxysilane hydrochloride; and phenylsilane-based coupling agents. These silane coupling agents can be used singly or in combination of two or more. As the moisture dispersant, a moisture dispersant generally used for coating can be preferably used. The type of the moisture dispersant is not particularly limited. Preferably, a copolymer-based moisture dispersant is used as the silane coupling agent, and specific examples of such a moisture dispersant include Disperbyk-110, 111, 161 and 180, BYK-W996, BYK-W9010, BYK-W903, and BYK-W940 (all of which are trade names), which are manufactured by BYK-Chemie Japan K.K. These moisture dispersants can be used singly or in combination of two or more.

The resin composition of the present embodiment contains the cyanate ester compound (A) and the epoxy resin (B), and has thermosetting properties. The resin composition may contain a curing accelerator for appropriately adjusting the curing rate of a resin component as necessary. As the curing accelerator, a curing accelerator generally used for a cyanate ester compound or an epoxy resin or the like can be preferably used. The type of the curing accelerator is not particularly limited. Specific examples of the curing accelerator include: organic metal salts such as zinc octylate, zinc naphthenate, cobalt naphthenate, copper naphthenate, iron(III) acetylacetonate, nickel octylate, and manganese octylate; phenol compounds such as phenol, xylenol, cresol, resorcin, catechol, octylphenol, and nonylphenol; alcohols such as 1-butanol and 2-ethyl hexanol; imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole; derivatives such as the carboxylates of these imidazoles, or the acid anhydride adducts thereof; amines such as dicyan diamide, benzyldimethylamine, and 4-methyl-N,N-dimethylbenzylamine; phosphorus compounds such as a phosphine-based compound, a phosphine oxide compound, a phosphonium compound, and a diphosphine compound; peroxides such as an epoxy-imidazole adduct compound, benzoyl peroxide, p-chlorobenzoyl peroxide, di-t-butyl peroxide, diisopropyl peroxy carbonate, and di-2-ethylhexyl peroxy carbonate; and azo compounds such as azobisisobutyronitrile. These curing accelerators can be used singly or in combination of two or more.

The used amount of the curing accelerator can be appropriately adjusted, taking into consideration the hardness of the resin, and the viscosity of the resin composition, or the like, and is not particularly limited. In general, the content is about 0.005 to 10 parts by mass based on 100 parts by mass of a resin solid content in the resin composition.

The resin composition of the present embodiment may contain one or more compounds selected from the group consisting of a cyanate ester compound other than the cyanate ester compound (A) represented by the formula (1) (hereinafter, referred to as "another cyanate ester compound"), a maleimide compound, a phenolic resin, an oxetane resin, a benzoxazine compound, and a compound having a polymerizable unsaturated group in a range in which the expected properties are not impaired. Among these, from the viewpoint of flame retardancy, preferred are one or more compounds selected from the group consisting of a maleimide compound and a cyanate ester compound other than the cyanate ester compound (A).

Another cyanate ester compound may be a resin having, in one molecule thereof, an aromatic moiety having at least one cyanate group. Examples of another cyanate ester compound include a compound represented by the following formula (3).

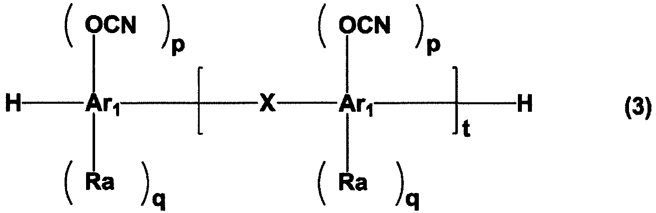

Herein, in the formula (3), Ar₁ represents a phenylene group, a naphthylene group, or a biphenylene group. A plurality of Ar₁ may be the same or different from each other. Ra represents a hydrogen atom, an alkyl group having 1 to 6 carbon atoms, an aryl group having 6 to 12 carbon atoms, an alkoxy group having 1 to 4 carbon atoms, or a group in which an alkyl group or alkylene group having 1 to 6 carbon atoms and an arylene group or aryl group having 6 to 12 carbon atoms are bound to each other. A plurality of Ra may be the same or different from each other. The aromatic ring in Ra may have a substituent group, and the position of a substituent group in Ar₁ and Ra can optionally selected. p represents the number of cyanate groups to be bound, and represents an integer of 1 to 3. q represents the number of Ra to be bound, and is 4-p when Ar₁ is a phenylene group, 6-p when Ar₁ is a naphthylene group, and 8-p when Ar₁ is a biphenylene group. t represents an integer of 0 to 50, but another cyanate ester compound may be a mixture of compounds having different t. X represents a single bond, a divalent organic group having 1 to 20 carbon atoms (wherein a hydrogen atom may be replaced by a heteroatom), a divalent organic group having 1 to 10 nitrogen atoms (for example, -N-R-N-(herein, R represents an organic group)), a carbonyl group (-CO-), a carboxy group (-C(=O)O-), a carbonyl dioxide group (-OC(=O)O-), a sulfonyl group (-SO₂-), a divalent sulfur atom, or a divalent oxygen atom.

The alkyl group in Ra of the formula (3) may have a chain structure or a cyclic structure (for example, a cycloalkyl group).

The alkyl group in Ra of the formula (3) and the hydrogen atom in the aryl group may be replaced by: halogen atoms such as fluorine and chlorine; alkoxy groups such as a methoxy group and a phenoxy group; and a cyano group or the like.

Specific examples of the alkyl group include a methyl group, an ethyl group, a propyl group, an isopropyl group, an n-butyl group, an isobutyl group, a tert-butyl group, an n-pentyl group, a 1-ethylpropyl group, a 2,2-dimethylpropyl group, a cyclopentyl group, a hexyl group, a cyclohexyl group, and a trifluoromethyl group.

Specific examples of the aryl group include a phenyl group, a xylyl group, a mesityl group, a naphthyl group, a phenoxyphenyl group, an ethylphenyl group, an o-, m- or p-fluorophenyl group, a dichlorophenyl group, a dicyanophenyl group, a trifluorophenyl group, a methoxyphenyl group, and an o-, m- or p-tolyl group. Furthermore, examples of the alkoxy group include a methoxy group, an ethoxy group, a propoxy group, an isopropoxy group, an n-butoxy group, an isobutoxy group, and a tert-butoxy group.

Specific examples of the divalent organic group having 1 to 20 carbon atoms in X of the formula (3) include: alkylene groups such as a methylene group, an ethylene group, a trimethylene group, and a propylene group; cycloalkylene groups such as a cyclopentylene group, a cyclohexylene group, and a trimethylcyclohexylene group; and divalent organic groups having an aromatic ring such as a biphenylmethylene group, a dimethylmethylene-phenylene-dimethylmethylene group, a fluorenediyl group, and a phthalide-diyl group. The hydrogen atom in the divalent organic group may be replaced by halogen atoms such as fluorine and chlorine; alkoxy groups such as a methoxy group and a phenoxy group, or a cyano group, or the like.

Examples of the divalent organic group having 1 to 10 nitrogen atoms in X of the formula (3) include an imino group and a polyimide group.

Examples of X in the formula (3) include a divalent group represented by the following formula (4).

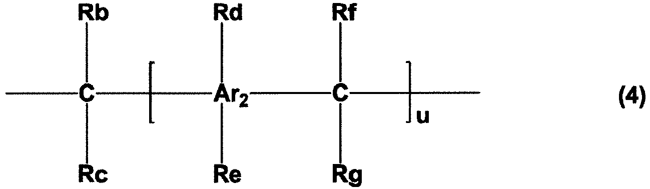

Herein, in the formula, Ar₂ represents a phenylene group, a naphthylene group, or a biphenylene group, and may be the same or different from each other when u is 2 or more. Rb, Rc, Rf, and Rg each independently represent a hydrogen atom, an alkyl group having 1 to 6 carbon atoms, an aryl group having 6 to 12 carbon atoms, a trifluoromethyl group, or an aryl group having at least one phenolic hydroxyl group. Rd and Re each independently represent a hydrogen atom, an alkyl group having 1 to 6 carbon atoms, an aryl group having 6 to 12 carbon atoms, an alkoxy group having 1 to 4 carbon atoms, or a hydroxyl group. u represents an integer of 0 to 5.

Furthermore, examples of X in the formula (3) also include a divalent group represented by the following formula.

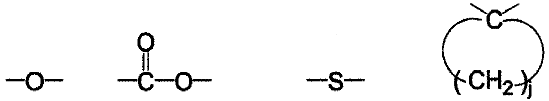

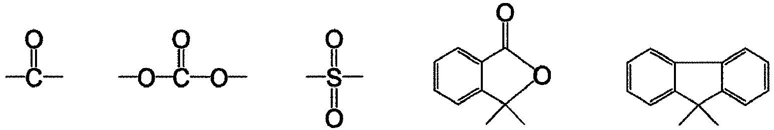

Herein, in the formula, j represents an integer of 4 to 7

Specific examples of Ar₂ in the formula (4) include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl group and the aryl group in Rb, Rc, Rd, Re, Rf, and Rg in the formula (4) have the same meanings as those in the formula (3).

Specific examples of a resin having, in one molecule, an aromatic moiety having at least one cyanate group represented by the formula (3) include, but are not particularly limited to, cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4- or 1-cyanato-3,5-dimethylbenzene, cyanatoethylbenzene, cyanatobutylbenzene, cyanatooctylbenzene, cyanatononylbenzene, 2-(4-cyanatophenyl)-2-phenylpropane(4-a-cumylphenol cyanate), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene(eugenol cyanate), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, 4-cyanatobenzoic acid methyl ester, 4-cyanatobenzoic acid phenyl ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-trimethylbenzene, 1,3-dicyanato-2,4,6-trimethylbenzene, 1,3-dicyanato-5-methylbenzene, 1-cyanato or 2-cyanatonaphthalene, 1-cyanato 4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6- or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenyl ethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethyl cyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl)ether, bis(4-cyanatophenyl)sulfide, bis(4-cyanatophenyl)sulfone, 4-cyanatobenzoic acid-4-cyanatophenyl ester (4-cyanatophenyl-4-cyanatobenzoate), bis-(4-cyanatophenyl)carbonate, 3,3-bis(4-cyanatophenyl)isobenzofuran-1(3H)-one(phenolphthalein cyanate), 3,3-bis(4-cyanato-3-methylphenyl)isobenzofuran-1(3H)-one(o-cresolphthalei n cyanate), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methyl anilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimid e, tris(3,5-dimethyl-4-cyanatobenzyl)isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, phenol novolac resins and cresol novolac resins (resins obtained by allowing phenol, alkyl-substituted phenol or halogen-substituted phenol to react with formaldehyde compounds such as formalin and paraformaldehyde in an acidic solution according to a known method), phenol aralkyl resins, cresol aralkyl resins, naphthol aralkyl resins, and biphenyl aralkyl resins (resins obtained by allowing a bishalogenomethyl compound represented by Ar₂-(CH₂Y)₂ to react with a phenol compound with an acidic catalyst or with no catalysts according to a known method, and resins obtained by allowing a bis(alkoxymethyl) compound represented by Ar₂-(CH₂OR)₂ or a bis(hydroxymethyl) compound represented by Ar₂-(CH₂OH)₂ to react with a phenol compound in the presence of an acidic catalyst), phenol denatured xylene formaldehyde resins (resins obtained by allowing a xylene formaldehyde resin to react with a phenol compound in the presence of an acidic catalyst according to a known method), resins obtained by cyanation of phenolic resins such as a phenol denatured dicyclopentadiene resin according to the same method as the above method, and these prepolymers. Another cyanate ester compounds can be used singly or in combination of two or more.

As the maleimide compound, a generally known maleimide compound can be used, as long as it is a compound having one or more maleimide groups in one molecule thereof. Examples of the maleimide compound include, but are not particularly limited to, 4,4-diphenylmethane bismaleimide, phenylmethanemaleimide, m-phenylene bismaleimide, 2,2-bis(4-(4-maleimidephenoxy)-phenyl)propane, 3,3-dimethyl-5,5-diethyl-4,4-diphenylmethane bismaleimide, 4-methyl-1,3-phenylene bismaleimide, 1,6-bismaleimide-(2,2,4-trimethyl)hexane, 4,4-diphenylether bismaleimide, 4,4-diphenylsulfone bismaleimide, 1,3-bis(3-maleimidephenoxy)benzene, 1,3-bis(4-maleimidephenoxy)benzene, polyphenylmethane maleimide, and prepolymers of these maleimide compounds, or prepolymers of the maleimide compounds and amine compounds. These maleimide compounds can be used singly or in combination of two or more.

A phenolic resin having two or more hydroxyl groups in one molecule is preferable, and a generally known phenolic resin can be used. Examples of the phenolic resin include, but are not particularly limited to, a bisphenol A-based phenolic resin, a bisphenol E-based phenolic resin, a bisphenol F-based phenolic resin, a bisphenol S-based phenolic resin, a phenol novolac resin, a bisphenol A novolac-based phenolic resin, a glycidyl ester-based phenolic resin, an aralkyl novolac-based phenolic resin, a biphenyl aralkyl-based phenol resin, a cresol novolac-based phenolic resin, a multifunctional phenolic resin, a naphthol resin, a naphthol novolac resin, a multifunctional naphthol resin, an anthracene-based phenolic resin, a naphthalene skeleton-modified novolac-based phenolic resin, a phenol aralkyl-based phenolic resin, a naphthol aralkyl-based phenolic resin, a dicyclopentadiene-based phenolic resin, a biphenyl-based phenolic resin, an alicyclic phenolic resin, a polyol-based phenolic resin, a phosphorus-containing phenolic resin, and a hydroxyl group-containing silicon resin. These phenolic resins can be used singly or in combination of two or more.

As an oxetane resin, a generally known oxetane resin can be used. Examples of the oxetane resin include, but are not particularly limited to, alkyloxetanes such as oxetane, 2-methyloxetane, 2,2-dimethyloxetane, 3-methyloxetane and 3,3-dimethyloxetane, 3-methyl-3-methoxymethyloxetane, 3,3-di(trifluoromethyl)perfluoxetane, 2-chloromethyloxetane, 3,3-bis(chloromethyl)oxetane and biphenyl-based oxetane, as well as OXT-101 (manufactured by TOAGOSEI Co., Ltd., trade name) and OXT-121 (manufactured by TOAGOSEI Co., Ltd., trade name) as commercial items. These oxetane resins can be used singly or in combination of two or more.

A benzoxazine compound is preferably a compound having two or more dihydrobenzoxazine rings in one molecule thereof, and a generally known benzoxazine compound can be used. Examples of the benzoxazine compound include, but are not particularly limited to, bisphenol A-based benzoxazine BA-BXZ (manufactured by KONISHI CHEMICAL IND CO., LTD., trade name), bisphenol F-based benzoxazine BF-BXZ (manufactured by KONISHI CHEMICAL IND CO., LTD., trade name), and bisphenol S-based benzoxazine BS-BXZ (manufactured by KONISHI CHEMICAL IND CO., LTD., trade name). These benzoxazine compounds can be used singly or in combination of two or more.

As a compound having a polymerizable unsaturated group, a generally known compound having a polymerizable unsaturated group can be used. Examples of the compound having a polymerizable unsaturated group include, but are not particularly limited to,: vinyl compounds such as ethylene, propylene, styrene, divinylbenzene, and divinylbiphenyl; (meth)acrylates of monohydric or polyhydric alcohols, such as methyl(meth)acrylate, 2-hydroxyethyl(meth)acrylate, 2-hydroxypropyl(meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy(meth)acrylates such as bisphenol A-based epoxy(meth)acrylate and bisphenol F-based epoxy(meth)acrylate; a benzocyclobutene resin; and a (bis)maleimide resin. These compound having a unsaturated group can be used singly or in combination of two or more. The above "(meth)acrylate" is a concept including acrylate, and methacrylate corresponding thereto.

Furthermore, the resin composition of the present embodiment can contain other thermosetting resins, thermoplastic resins and the oligomers thereof, various polymer compounds such as elastomers, flame-retardant compounds, and various additives or the like in a range in which the expected properties are not impaired. These compounds are not particularly limited as long as they are generally used. Examples of the flame-retardant compound include: bromine compounds such as 4,4'-dibromobiphenyl; nitrogen compounds such as phosphoric acid ester, melamine phosphate, a phosphorus-containing epoxy resin, melamine, and benzoguanamine; and oxazine ring-containing compounds and silicone compounds. Examples of the various additives include an ultraviolet absorber, an antioxidant, a photopolymerization initiator, a fluorescent brightener, a photosensitizer, a dye, a pigment, a thickener, a fluidity adjuster, a lubricant, a defoaming agent, a dispersant, a leveling agent, a brightening agent, and a polymerization inhibitor. These can be used singly or in combination of two or more as required.

The resin composition of the present embodiment can contain an organic solvent as necessary. In this case, the resin composition of the present embodiment can be used as an aspect (that is, a solution or a varnish) in which at least a part, and preferably all of the above-described various resin components which are contained therein are dissolved in an organic solvent, or compatible with it. As such an organic solvent, a known organic solvent can be appropriately used, as long as it is able to dissolve or be compatible with at least a part of, and preferably all of the above-described various resin components, and the type of the organic solvent is not particularly limited. Specific examples of the organic solvent include: ketones such as acetone, methyl ethyl ketone, methyl isobutyl ketone; cellosolve solvents such as propylene glycol monomethyl ether and propylene glycol monomethyl ether acetate; ester solvents such as ethyl lactate, methyl acetate, ethyl acetate, butyl acetate, isoamyl acetate, ethyl lactate, methyl methoxypropionate, and methyl hydroxyisobutyrate; polar solvents including amides such as dimethylacetamide and dimethylformamide; and non-polar solvents including aromatic hydrocarbons such as toluene and xylene. These can be used singly or in combination of two or more.

The resin composition of the present embodiment can be used as an insulating layer of a printed wiring board, and a semiconductor package material, for example. For example, a prepreg can be produced by impregnating or coating a base material with a solution prepared by dissolving the resin composition of the present embodiment in a solvent, followed by drying.

A build-up film or dry film solder resist can be produced by applying a solution prepared by dissolving the resin composition of the present embodiment in a solvent onto a removable plastic film used as a base material, followed by drying. Herein, the solvent can be dried by heating it at a temperature of, for example, 20 to 150°C for 1 to 90 minutes. The resin composition can be used in an uncured state in which only the solvent is dried away from the resin composition, or as necessary, the film can be used in a semicured (B-staged) state.

Hereinafter, the prepreg of the present embodiment will be described in detail. The prepreg of the present embodiment is prepared by impregnating or coating a base material with the resin composition of the present embodiment. Specifically, the prepreg includes a base material and the resin composition of the present embodiment with which the base material is impregnated or coated. A method for producing a prepreg is not particularly limited as long as the method combines the resin composition of the present embodiment with a base material to produce a prepreg. For example, the prepreg of the present embodiment can be produced by impregnating or coating a base material with the resin composition of the present embodiment, and then drying the resulting base material at 120 to 220°C for about 2 to 15 minutes so as to semicure the base material. During this operation, the amount of a resin composition attached to a base material, namely, the amount of a resin composition to a total amount of a prepreg after being semicured (when the resin composition contains the inorganic filler (C), the amount of the inorganic filler (C) is also contained in the amount of the resin composition) is preferably in a range of 20 to 99% by mass.

As a base material used when the prepreg of the present embodiment is produced, a known base material used for various printed wiring board materials can be used. Examples of such a base material include, but are not particularly limited to, woven cloths of glass fibers of E-glass, D-glass, L-glass, S-glass, T-glass, Q-glass, UN-glass, NE-glass, and spherical glass or the like, inorganic fibers of materials other than glass such as quartz, organic fibers of polyimide, polyamide, and polyester or the like, and liquid crystal polyester. As the shape of the base material, woven cloth, nonwoven cloth, roving, chopped strand mat, and surfacing mat or the like are known, and any may be used. The base materials can be used singly or in combination of two or more. The thickness of the base material is not particularly limited. If the base material is used for a laminate, the thickness of the base material is preferably set in a range of 0.01 to 0.2 mm. From the viewpoint of dimension stability, a woven fabric, on which a ultra-opening treatment or a weather-stripping treatment has been performed, is particularly preferable. Furthermore, a glass woven fabric, the surface of which has been treated with a silane coupling agent, such as an epoxysilane treatment or an aminosilane treatment, is preferable from the viewpoint of heat resistance after moisture absorption. A liquid crystal polyester woven fabric is preferable in terms of electrical properties.

The metal foil clad laminate of the present embodiment is produced by placing one or more of the above described prepreg and then disposing a metallic foil on one or both surfaces of the prepreg, followed by laminate molding. Specifically, the metal foil clad laminate of the present embodiment includes one or more of the above described prepreg and a metallic foil disposed on one or both surfaces of the prepreg. Specifically, one of the above described prepreg is placed or a plurality of the above described prepregs are laminated on one another, and a metallic foil such as a copper or aluminum foil is disposed on one or both surfaces of the layer, followed by laminate molding, so as to produce a metal foil clad laminate. The metallic foil used herein is not particularly limited, as long as it is used as a material for printed wiring boards. A copper foil such as a rolled copper foil or an electrolytic copper foil is preferable. The thickness of the metallic foil is not particularly limited, and is preferably 2 to 70 µm, and more preferably 3 to 35 µm. With regard to molding conditions, means for laminates and multilayer boards used for usual printed wiring boards can be applied. For example, a multistage pressing machine, a multistage vacuum pressing machine, a continuous molding machine, or an autoclave molding machine or the like is used, and laminate molding is carried out at a temperature of 180 to 350°C, for a heating time of 100 to 300 minutes, and at a surface pressure of 20 to 100 kg/cm², so as to produce the metal foil clad laminate of the present embodiment. The above described prepreg is combined with a circuit board used for inner layer, which has been produced separately. The combined product can be subjected to laminate molding, so as to produce a multilayer board. Specifically, the multilayer board includes the prepreg and a circuit board used for inner layer, and is obtained by laminating one or two or more of the prepregs and one or two or more of the circuit boards used for inner layer. As a method for producing such a multilayer board, for example, a copper foil (for example, a thickness of 35 µm) is disposed on both surfaces of one of the above described prepreg, and the resultant is then subjected to laminate molding under the above described conditions. Thereafter, an internal circuit is formed, and the formed circuit is then subjected to a blackening treatment to form an internal circuit board. Thereafter, this internal circuit boards and the above described prepregs are disposed alternatively on a one-by-one base. Furthermore, a copper foil is disposed as an outermost layer, and the thus obtained layer is subjected to laminate molding under the above described conditions, and preferably under vacuum. Thereby, a multilayer board can be produced.

The metal foil clad laminate of the present embodiment can be preferably used as a material for printed wiring boards. The printed wiring board can be produced according to an usual method, and the production method is not particularly limited. Hereinafter, an example of the method for producing the printed wiring board will be described. First, the above described metal foil clad laminate such as a copper-clad laminate is prepared. Subsequently, the surface of the metal foil clad laminate is subjected to etching processing to form an internal circuit, thereby producing an internal base board. The surface of the internal circuit of this internal base board is subjected to a surface treatment for enhancing adhesion strength, as necessary. Thereafter, a predetermined number of the above described prepregs are laminated on the surface of the internal circuit, and further, a metallic foil used as an external circuit is laminated on the outside thereof. The resultant is subjected to integral molding by heating and compression. As such, a multilayer laminate in which an insulating layer containing a base material and a hardened product of a resin composition is formed between an internal circuit and a metallic foil used as an external circuit, is produced. Subsequently, this multilayer laminate is subjected to hole-making processing of making a through hole or a via hole, and a plated metal coating for conducting the internal circuit and the metallic foil used as an external circuit to the wall surface of the hole is then formed. The metallic foil used as an external circuit is subjected to etching processing to form an external circuit, thereby producing a printed wiring board.

The printed wiring board obtained as described above includes an insulating layer and a conductor layer formed on the surface of the insulating layer, wherein the insulating layer contains the resin composition of the present embodiment. Specifically, the insulating layer in the printed wiring board is derived from the above-described prepreg of the present embodiment (a base material, and the resin composition of the present embodiment with which the base material is impregnated or coated) and the resin composition layer of the above-described metal foil clad laminate of the present embodiment (a layer containing the resin composition of the present embodiment).

The laminate of the present embodiment can be obtained by applying a solution in which the resin composition of the present embodiment is dissolved in a solvent or compatible with it, to a support, followed by drying. Specifically, a laminate of the present embodiment includes a support and a resin phase disposed on the surface of the support and prepared by coating and drying of the resin composition. Examples of the support used herein include, but are not particularly limited to, a polyethylene film, a polypropylene film, a polycarbonate film, a polyethylene terephthalate film, an ethylene tetrafluoroethylene copolymer film, demolding films obtained by applying a demolding agent on the surface of these films, organic film base materials such as a polyimide film, conductor foils such as a copper foil and an aluminum foil, platy supports such as a glass plate, an SUS plate, and FRP. Examples of the applying method include a method which includes applying a solution in which the resin composition of the present embodiment is dissolved in a solvent or compatible with it, onto a support using a bar coater, a die coater, a doctor blade, and a baker applicator or the like. After applying, the support may be removed or etched from the laminate obtained by drying, so as to form a monolayer sheet (resin sheet). The above described resin composition of the present embodiment is dissolved in a solvent or compatible with it, to obtain a solution. The obtained solution is then supplied to a mold having a sheet-like cavity, and then molded into a sheet by drying it or the like, so that a monolayer sheet (resin sheet) can also be obtained without using supports.

In the production of the monolayer or laminate of the present embodiment, drying conditions applied upon the removal of the solvent are not particularly limited. From the viewpoint of suppressing the residual solvent in the resin composition and the curing of the resin composition, drying is preferably carried out at a temperature of 20 to 200°C for 1 to 90 minutes. The thickness of the resin layer in the monolayer or laminate of the present embodiment can be adjusted depending on the concentration of the solution of the resin composition of the present embodiment and the thickness of the solution coated, and the thickness of the resin layer is not particularly limited. In general, the thickness of the resin layer is preferably 0.1 to 500 µm. The residual solvent during drying is more easily suppressed by setting the thickness to 500 µm or less.

According to the present invention, a prepreg, a laminate, and a metal foil clad laminate or the like which have excellent heat resistance after moisture absorption, flame retardancy, and solvent solubility can be realized, and a high-performance printed wiring board can be realized. According to a preferred aspect of the present invention, a resin composition containing only a non-halogen compound having excellent solvent solubility (in other words, a resin composition containing no halogen compound, namely, a non-halogen resin composition), a prepreg, a laminate, and a metal foil clad laminate or the like can also be realized, and the industrial practicability of the resin composition is extremely high.

### Examples

Hereinafter, the present invention will be described more in detail with reference to Synthetic Examples, Examples, and Comparative examples. However, the present invention is not particularly limited by these Examples.

### (Measurement of Weight-Average Molecular Weight Mw)

A solution (10 µL) prepared by dissolving 1 g of a sample in 100 g of tetrahydrofuran (solvent) was injected into high performance liquid chromatography (manufactured by Hitachi High-Technologies Corporation, high performance liquid chromatograph, product name "LachromElite"), and the analysis was then carried out. As columns, two columns of TSK gel GMHHR-M (30 cm in length × 7.8 mm in inner diameter) manufactured by Tosoh Corporation were used, and as a mobile phase, tetrahydrofuran was used. The flow rate was set at 1 mL/min, and the detector was RI. The weight-average molecular weight Mw was obtained according to a GPC method using polystyrene as a standard substance.

### (Synthetic Example 1)

Synthesis of Cyanate Ester Compound Obtained by Cyanation of Naphthol-Modified Meta-Xylene Glycol Resin (hereinafter, also abbreviated as "SNCN-MX")

### <Synthesis of Naphthol-Modified Meta-Xylene Glycol Resin>

420.0 g (3.04 mol) of meta-xylene glycol and 876.5 g (6.08 mol) of 1-naphthol were added into a four-necked flask (internal volume: 2 L) equipped with a Liebig condenser, a thermometer and an impeller under a nitrogen current, and the obtained mixture was then melted by heating at 90°C. While stirring, 260 mg (1.51 mmol) of p-toluenesulfonic acid was added to the heat-melted material, and the reaction was then carried out for 3 hours, while the temperature was increased to 170°C. The reaction product was neutralized and washed with water, and unreacted raw materials were then removed under reduced pressure, to obtain 945 g of a naphthol-modified meta-xylene glycol resin. The OH group equivalent of the obtained resin was 220 g/eq.

### <Synthesis of SNCN-MX>

720 g (OH group equivalent: 220 g/eq., 3.27 mol in terms of hydroxy groups, weight-average molecular weight Mw: 820) of the naphthol-modified meta-xylene glycol resin obtained by the above described method and 496.8 g (4.91 mol) of triethylamine (in an amount of 1.5 mol based on 1 mol of hydroxy group of the naphthol-modified meta-xylene glycol resin) were dissolved in 3960 g of dichloromethane, and the obtained solution was defined as a solution 1.

The solution 1 was then poured into a mixture of 321.9 g (5.24 mol, in an amount of 1.6 mol based on 1 mol of hydroxy group of the naphthol-modified meta-xylene glycol resin) of cyanogen chloride, 751.0 g of dichloromethane, 497.2 g (4.91 mol, in an amount of 1.5 mol based on 1 mol of hydroxy group of the naphthol-modified meta-xylene glycol resin) of 36% hydrochloric acid and 3082.5 g of water under stirring, while keeping the solution temperature at -2°C to -0.5°C, over 75 minutes. After completion of the pouring of the solution 1, the reaction solution was stirred at the same temperature as described above for 30 minutes, and a solution prepared by dissolving 132.47 g (1.31 mol) of triethylamine (in an amount of 0.4 mol based on 1 mol of hydroxy group of the naphthol-modified meta-xylene glycol resin) in 132.5 g of dichloromethane (solution 2) was poured into the reaction solution over 30 minutes. After completion of the pouring of the solution 2, the reaction solution was stirred at the same temperature as described above for 30 minutes, and the reaction was then terminated.

Thereafter, the reaction solution was left at rest, so that an organic phase was separated from a water phase. The obtained organic phase was washed with 2000 g of water five times. The electrical conductivity of the waste water at the 5th water washing was 20 µS/cm, and it was confirmed that an ionic compound to be removed was sufficiently removed by washing with water.

After completion of the water washing, the organic phase was concentrated under reduced pressure, and finally, it was concentrated and dried at 90°C for 1 hour to obtain 777 g of the cyanate ester compound SNCN-MX (orange viscous product) of interest represented by the following formula (5). The weight-average molecular weight Mw of the cyanate ester compound SNCN-MX represented by the following formula (5) was 1040. The IR spectrum of the cyanate ester compound SNCN-MX exhibited absorption of 2250 cm⁻¹ (cyanate ester group) and did not exhibit the absorption of hydroxy group.

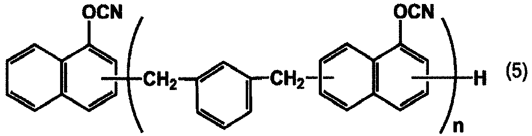

The cyanate ester compound SNCN-MX was a mixture of cyanate ester compounds in which n in the above formula (5) were in a range of 1 to 10.

### (Synthetic Example 2)

Synthesis of α-Naphthol Aralkyl-Based Cyanate Ester Compound (hereinafter, also abbreviated as "SNCN")

### <Synthesis of SNCN>

300 g (1.28 mol in terms of hydroxy groups) of a 1-naphthol aralkyl resin (manufactured by Nippon Steel & Sumikin Chemical Co., Ltd.) and 194.6 g of triethylamine (1.92 mol, in an amount of 1.5 mol based on 1 mol of hydroxy group of the 1-naphthol aralkyl resin) were dissolved in 1800 g of dichloromethane, and the obtained solution was defined as a solution 3.

The solution 3 was then poured into a mixture of 125.9 g (2.05 mol) (in an amount of 1.6 mol based on 1 mol of hydroxy group of the 1-naphthol aralkyl resin) of cyanogen chloride, 293.8 g of dichloromethane, 194.5 g (1.92 mol) (in an amount of 1.5 mol based on 1 mol of hydroxy group of the 1-naphthol aralkyl resin) of 36% hydrochloric acid and 1205.9 g of water under stirring, while keeping the solution temperature at -2°C to -0.5°C, over 30 minutes. After completion of the pouring of the solution 3, the reaction solution was stirred at the same temperature as described above for 30 minutes, and a solution (solution 4) prepared by dissolving 65 g (0.64 mol) (in an amount of 0.5 mol based on 1 mol of hydroxy group of the 1-naphthol aralkyl resin) of triethylamine in 65 g of dichloromethane was poured into the reaction solution over 10 minutes. After completion of the pouring of the solution 4, the reaction solution was stirred at the same temperature as described above for 30 minutes, and the reaction was then terminated.

Thereafter, the reaction solution was left at rest, so that an organic phase was separated from a water phase. The obtained organic phase was washed with 1300 g of water five times. The electrical conductivity of the waste water at the 5th water washing was 5 µS/cm), and it was confirmed that an ionic compound to be removed was sufficiently removed by washing with water.

After completion of the water washing, the organic phase was concentrated under reduced pressure, and finally, it was concentrated and dried at 90°C for 1 hour to obtain 331 g of the cyanate ester compound SNCN (orange viscous product) of interest represented by the following formula (6). The weight-average molecular weight Mw of the obtained cyanate ester compound SNCN was 600. The IR spectrum of the cyanate ester compound SNCN exhibited absorption of 2250 cm⁻¹ (cyanate ester group) and did not exhibit the absorption of hydroxy group.

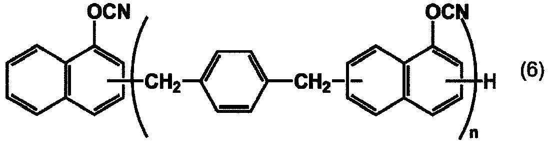

The cyanate ester compound SNCN was a mixture of cyanate ester compounds in which n in the above formula (6) were in a range of 1 to 5.

### (Example 1)

50 parts by mass of the SNCN-MX obtained by Synthetic Example 1, 50 parts by mass of a biphenyl aralkyl-based epoxy resin (product name: "NC-3000-FH", manufactured by Nippon Kayaku Co., Ltd.), 100 parts by mass of fusion silica (product name: "SC2050MB", manufactured by Admatechs), and 0.10 part by mass of zinc octylate (manufactured by Nihon Kagaku Sangyo Co., Ltd.) were mixed to obtain a varnish. This varnish was diluted with methyl ethyl ketone, and an E-glass woven fabric having a thickness of 0.1 mm was then impregnated and coated with this varnish. The resulting product was dried by heating at 165°C for 5 minutes, to obtain a prepreg containing 50 parts by mass of a resin solid content based on 100 parts by mass of the total amount of the resin solid content and fusion silica.

The obtained eight prepregs were laminated on one another, and electrolytic copper foils (manufactured by JX Nippon Mining & Metals Corporation) each having a thickness of 12 µm were disposed on both sides in a lamination direction of the obtained prepreg product. The obtained product was subjected to lamination molding at a pressure of 30 kg f/cm², at a temperature of 220°C for 120 minutes, to obtain a metal foil clad laminate in which the thickness of an insulating layer was 0.8 mm. Using the obtained metal foil clad laminate, a water absorption rate, heat resistance after moisture absorption, and flame retardancy were evaluated. The results are shown in Table 1.

50 parts by mass of methyl ethyl ketone was added to 50 parts by mass of the SNCN-MX obtained by Synthetic Example 1, and these were mixed to obtain a homogeneous solution. Solvent solubility was evaluated using the obtained SNCN-MX solution. The results are shown in Table 1.

### (Measurement Methods and Evaluation Methods)

### 1) Water Absorption Rate

In accordance with JIS C6480, a sample with a size of 30 mm × 30 mm was treated using a pressure cooker tester (manufactured by Hirayama Manufacturing Corp., model: PC-3) at 121°C at a pressure of 2 atm for 1, 3, and 5 hours. Thereafter, a water absorption rate was measured.

### 2) Heat Resistance After Moisture Absorption

A test piece prepared by removing the entire copper foil, other than a half of one surface of a sample of 50 mm × 50 mm, by etching was treated using a pressure cooker tester (manufactured by Hirayama Manufacturing Corp., model: PC-3) at 121°C at a pressure of 2 atm for 3, 4 and 5 hours. Thereafter, the test piece was immersed in a solder at 260°C for 60 seconds. Thereafter, a change in the appearance was observed by visual inspection. The results shown in Table 1 are (the number of test pieces having blisters occurred/ the number of test pieces provided for tests).

### 3) Flame Retardancy

The copper foil was completely removed from a sample of 13 mm × 130 mm by etching, to obtain a test piece. Using this test piece, a flame retardancy test was carried out according to a UL94 vertical test method (n=5).

### 4) Solvent Solubility

After the SNCN-MX solution was stored in a 100 mL glass bottle at 25°C for 60 days, it was visually confirmed whether precipitation occurred at the bottom of the glass bottle. The case where the precipitation did not occur was evaluated as "A", and the case where the precipitation occurred was estimated as "B".

### (Comparative Example 1)

A metal foil clad laminate in which the thickness of an insulating layer was 0.8 mm was obtained in the same manner as in Example 1 except that 50 parts by mass of a bisphenol A-based cyanate ester compound (product name: "CA210" manufactured by Mitsubishi Gas Chemical Company, Inc.) was used instead of 50 parts by mass of the SNCN-MX; the used amount of zinc octylate was changed to 0.03 part by mass from 0.10 part by mass; and a temperature during drying after impregnating and coating was changed to 150°C from 165°C. The various measurement and evaluation results are shown in Table 1.

### (Comparative Example 2)

A metal foil clad laminate in which the thickness of an insulating layer was 0.8 mm was obtained in the same manner as in Example 1 except that 50 parts by mass of a novolac-based cyanate ester compound (product name: "Primaset PT-30" manufactured by Lonza Japan) was used instead of 50 parts by mass of the SNCN-MX; the used amount of zinc octylate was changed to 0.04 part by mass from 0.10 part by mass; and a time during drying after impregnating and coating was changed to 4 minutes from 5 minutes. The various measurement and evaluation results are shown in Table 1.

### (Comparative Example 3)

A metal foil clad laminate in which the thickness of an insulating layer was 0.8 mm was obtained in the same manner as in Example 1 except that 50 parts by mass of the SNCN obtained in Synthetic Example 2 was used instead of 50 parts by mass of the SNCN-MX, and the used amount of zinc octylate was changed to 0.11 part by mass from 0.10 part by mass. The various measurement and evaluation results are shown in Table 1.

**[Table 1]**

| | | Example 1 | Comparative Example 1 | Comparative : Example 2 | Comparative Example 3 |
|---|---|---|---|---|---|
| Water absorption rate (%) | After processing for 5 hours | 0.28 | 0.38 | 0.52 | 0.28 |
| Heat resistance after moisture absorption | After processing for 5 hours | 0/4 | 3/4 | 1/4 | 0/4 |
| Flame retardancy | | V-0 i | V-1 | V-1 | V-1 |
| Solvent solubility | | A | A | A | B |

As is apparent from Table 1, it was confirmed that a prepreg and a printed wiring board or the like which have not only low water-absorbing property but also excellent heat resistance after moisture absorption and flame retardancy can be realized with the use of the resin composition having excellent solvent solubility of the present invention.

The present application is based on a Japanese patent application filed with the Japan Patent Office on Oct. 25, 2013 (Japanese Patent Application No. 2013-222023); and the disclosure of which is hereby incorporated by reference.

### Industrial Applicability

As is apparent from the above description, the resin composition of the present invention is useful in various intended uses such as electrical and electronic materials, machine tool materials, and aviation materials. More specifically, the resin composition of the present invention can be widely and effectively used, for example, as an electrical insulating material, a semiconductor plastic package, a sealing material, an adhesive, a laminating material, a resist, and a build-up laminating material or the like. In particular, the resin composition of the present invention can be particularly effectively used as a material for printed wiring boards which is applicable to high integration and densification of recent information terminal devices or communication devices or the like. The laminate and metal foil clad laminate of the present invention, or the like have not only low water-absorbing property but also excellent heat resistance after moisture absorption and flame retardancy. Accordingly, the industrial practicability of the resin composition is extremely high.

## Claims

1. A resin composition comprising one or two or more cyanate ester compounds (A) represented by the following formula (1) and an epoxy resin (B): 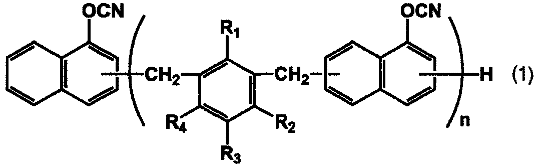 wherein R₁, R₂, R₃, and R₄ represent a hydrogen atom or an alkyl group having 1 to 10 carbon atoms, and may be the same or different from each other; and n represents an integer of 1 to 50.

2. The resin composition according to claim 1, wherein a content of the cyanate ester compound (A) is 1 to 90 parts by mass based on 100 parts by mass of a resin solid content in the resin composition.

3. The resin composition according to claim 1 or 2, further comprising an inorganic filler (C).

4. The resin composition according to claim 3, wherein a content of the inorganic filler (C) is 50 to 1600 parts by mass based on 100 parts by mass of a resin solid content in the resin composition.

5. The resin composition according to any one of claims 1 to 4, further comprising one or more compounds selected from the group consisting of a maleimide compound and a cyanate ester compound other than the cyanate ester compound (A).

6. The resin composition according to any one of claims 1 to 5, wherein the epoxy resin (B) is one or more selected from the group consisting of a biphenyl aralkyl-based epoxy resin, a naphthylene ether-based epoxy resin, a multifunctional phenol-based epoxy resin, and a naphthalene-based epoxy resin.

7. A prepreg comprising a base material and the resin composition according to any one of claims 1 to 6 with which the base material is impregnated or coated.

8. A metal foil clad laminate comprising one or more of the prepreg according to claim 7 and a metallic foil disposed on one or both surfaces of the prepreg.

9. A laminate comprising a support and a resin layer formed on a surface of the support by coating and drying of the resin composition according to any one of claims 1 to 6.

10. A printed wiring board comprising an insulating layer and a conductor layer formed on a surface of the insulating layer, wherein the insulating layer comprises the resin composition according to any one of claims 1 to 6.

## Patentansprüche

1. Harzzusammensetzung, die ein oder zwei oder mehr Cyanatesterverbindungen (A), die durch die folgende Formel (1) dargestellt sind, und ein Epoxidharz (B) umfasst: 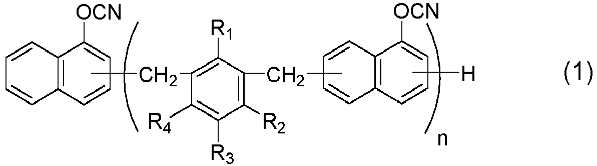 worin R₁, R₂, R₃ und R₄ für ein Wasserstoffatom oder eine Alkylgruppe mit 1 bis 10 Kohlenstoffatomen stehen und gleich oder verschieden voneinander sein können; und n für eine ganze Zahl von 1 bis 50 steht.

2. Harzzusammensetzung gemäß Anspruch 1, wobei der Gehalt der Cyanatesterverbindung (A) 1 bis 90 Massenteile bezogen auf 100 Massenteile des Feststoffgehalts des Harzes in der Harzzusammensetzung beträgt.

3. Harzzusammensetzung gemäß Anspruch 1 oder 2, die ferner einen anorganischen Füllstoff (C) umfasst.

4. Harzzusammensetzung gemäß Anspruch 3, wobei der Gehalt des anorganischen Füllstoffs (C) 50 bis 1600 Massenteile bezogen auf 100 Massenteile des Feststoffgehalts des Harzes in der Harzzusammensetzung beträgt.

5. Harzzusammensetzung gemäß mindestens einem der Ansprüche 1 bis 4, die ferner ein oder mehr Verbindungen ausgewählt aus der Gruppe bestehend aus einer Maleimidverbindung und einer anderen Cyanatesterverbindung als der Cyanatesterverbindung (A) umfasst.

6. Harzzusammensetzung gemäß mindestens einem der Ansprüche 1 bis 5, wobei das Epoxidharz (B) eines oder mehrere ausgewählt aus der Gruppe bestehend aus einem Epoxidharz auf Biphenylaralkylbasis, einem Epoxidharz auf Naphthylenetherbasis, einem Epoxidharz auf Basis eines multifunktionellen Phenols und einem Epoxidharz auf Naphthalinbasis ist.

7. Prepeg, umfassend ein Basismaterial und die Harzzusammensetzung gemäß mindestens einem der Ansprüche 1 bis 6, mit der das Basismaterial imprägniert oder beschichtet ist.

8. Metallfolien-kaschiertes Laminat, umfassend ein oder mehrere Prepegs gemäß Anspruch 7 und eine Metallfolie, die auf einer oder beiden Oberflächen des Prepegs angeordnet ist.

9. Laminat, umfassend einen Träger und eine Harzschicht, die auf einer Oberfläche des Trägers durch Beschichten mit und Trocknen der Harzzusammensetzung gemäß mindestens einem der Ansprüche 1 bis 6 ausgebildet ist.

10. Gedruckte Leiterplatte, umfassend eine Isolierschicht und eine Leiterschicht, die auf einer Oberfläche der Isolierschicht ausgebildet ist, wobei die Isolierschicht die Harzzusammensetzung gemäß mindestens einem der Ansprüche 1 bis 6 umfasst.

## Revendications

1. Composition de résine comprenant un ou deux composés d'ester d'acide cyanique (A) ou plus représentés par la formule (1) suivante et une résine époxy (B) : 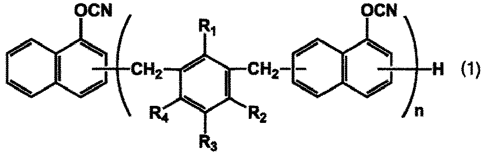 dans laquelle R₁, R₂, R₃, et R₄ représentent un atome d'hydrogène ou un groupe alkyle ayant de 1 à 10 atomes de carbone, et peuvent être identiques ou différents les uns des autres ; et n représente un entier de 1 à 50.

2. Composition de résine selon la revendication 1, dans laquelle une teneur du composé d'ester d'acide cyanique (A) est de 1 à 90 parties en masse sur la base de 100 parties en masse d'une teneur en matière solide de résine dans la composition de résine.

3. Composition de résine selon la revendication 1 ou 2, comprenant en outre une charge inorganique (C).

4. Composition de résine selon la revendication 3, dans laquelle une teneur de la charge inorganique (C) est de 50 à 1600 parties en masse sur la base de 100 parties en masse d'une teneur en matière solide de résine dans la composition de résine.

5. Composition de résine selon l'une quelconque des revendications 1 à 4, comprenant en outre un ou plusieurs composés sélectionnés dans le groupe constitué d'un composé de maléimide et d'un composé d'ester d'acide cyanique autre que le composé d'ester d'acide cyanique (A).

6. Composition de résine selon l'une quelconque des revendications 1 à 5, dans laquelle la résine époxy (B) est une ou plusieurs sélectionnée(s) dans le groupe constitué d'une résine époxy à base de biphényl aralkyle, d'une résine époxy à base d'éther de naphthylène, une résine époxy à base de phénol multifonctionnel, et d'une résine époxy à base de naphtalène.

7. Préimprégné comprenant un matériau de base et la composition de résine selon l'une quelconque des revendications 1 à 6 avec laquelle le matériau de base est imprégné ou revêtu.

8. Stratifié revêtu d'une feuille métallique comprenant un ou plusieurs du préimprégné selon la revendication 7 et d'une feuille métallique disposée sur une ou les deux surfaces du préimprégné.

9. Stratifié comprenant un support et une couche de résine formée sur une surface du support par revêtement et séchage de la composition de résine selon l'une quelconque des revendications 1 à 6.

10. Carte de circuit imprimé comprenant une couche isolante et une couche conductrice formée sur une surface de la couche isolante, dans laquelle la couche isolante comprend la composition de résine selon l'une quelconque des revendications 1 à 6.
